# EUROPEAN PATENT SPECIFICATION

(11) **EP 4 451 420 B1**
(45) Date of publication and mention of the grant of the patent: **21.01.2026**
(21) Application number: 24170788.4
(22) Date of filing: 17.04.2024
(51) Int. Cl.: H01M 10/42, H01M 10/0587

(54) **BATTERY IDENTIFICATION DEVICE, BATTERY IDENTIFICATION METHOD, AND STORAGE MEDIUM**
BATTERIEIDENTIFIKATIONSVORRICHTUNG, BATTERIEIDENTIFIKATIONSVERFAHREN UND SPEICHERMEDIUM
DISPOSITIF D'IDENTIFICATION DE BATTERIE, PROCÉDÉ D'IDENTIFICATION DE BATTERIE ET SUPPORT D'INFORMATIONS

(30) Priority: 18.04.2023 JP 2023068125
(43) Date of publication of application: 23.10.2024
(73) Proprietor: Yokogawa Electric Corporation, Tokyo 180-8750 (JP); HONDA MOTOR CO., LTD., Tokyo 105-8404 (JP)
(72) Inventor: OKANO, Jun, Saitama, 351-0193 (JP); ONOUE, Yukiko, Tokyo, 107-8556 (JP); TOMINAGA, Yuki, Saitama, 351-0193 (JP); OMICHI, Kaoru, Saitama, 351-0193 (JP); TAKENAKA, Kazuma, Tokyo, 180-8750 (JP); TERAO, Minako, Tokyo, 180-8750 (JP); NOGUCHI, Naoki, Tokyo, 180-8750 (JP); TSUKANO, Masahito, Tokyo, 180-8750 (JP); YOSHITAKE, Satoshi, Tokyo, 180-8750 (JP)
(74) Representative: Kiwit, Benedikt

(56) References cited:
- JP-A- H06 215 802
- JP-B2- 5 167 521
- US-A1- 2015 123 669

## Description

### BACKGROUND

### Field of the Invention

The present invention relates to a battery identification device, a battery identification method, and a storage medium.

### Description of Related Art

In the related art, a method of identifying the type of battery based on the direct-current internal resistance at the time of charging of the battery and a direct-current internal resistance at the time of discharging is known (PCT International Publication No. WO 2015 / 133 068 A1). In this method, a resistor with a predetermined resistance value is attached to a battery in advance, and a type of the battery is determined by measuring the resistance value at the time of identification. A method of attaching an IC chip to a battery and determining a type of the battery based on an identification signal output from the IC chip is also known.

### SUMMARY

However, in the related art, a component such as a resistor or an IC chip has to be attached to a battery, which increases costs. When such a component is imitated, the component may be attached to an unintended battery, and thus the type of battery cannot be correctly identified.

JP H06 215 802 A discloses a measuring device which determines the chemical composition of a battery or accumulator by measuring the induction response thereof to an alternating magnetic field. The measuring device comprises an exciting coil coupled to a biasing means to generate said alternating magnetic field, a positioning means for positioning the battery or accumulator in the alternating magnetic field, and a measuring means for measuring the induction response of the battery or accumulator, wherein a ferromagnetic portion of the battery or accumulator is saturated by the applied magnetic field.

The present invention was made in consideration of the aforementioned circumstances, and an objective thereof is to provide a battery identification device, a battery identification method, and a storage medium that can identify the type of battery without attaching an identification component thereto.

A battery identification device, a battery identification method, and a storage medium according to the present invention employ the following configurations.
(1) According to an aspect of the present invention, there is provided a battery identification device for identifying a tubular battery including a wound product in which electrodes are wound, the battery identification device including a storage device storing a program and a hardware processor, wherein the hardware processor executes the program stored in the storage device to perform: applying a current to the battery; measuring a magnetic field generated with application of the current; and acquiring a type of the battery which is determined by comparing the measurement result of the magnetic field with magnetic field information correlated with the type of battery.

The battery identification device further includes a sensor configured to measure a magnetic field in the vicinity of a surface of the battery while moving relative to a side surface of the battery.

The battery identification device further includes a rotating mechanism configured to rotate the battery with an axis passing through both end surfaces of the tubular battery as a rotation axis, and the sensor measures the magnetic field while moving in a circumferential direction relative to the side surface of the battery using the rotating mechanism.

(2) In the aspect of (1), the rotation axis passes through the center of one end surface of the battery and the center of the other end surface of the battery.

(3) In the aspect of (1), the sensor measures the magnetic field while moving parallel to the rotation axis.

(4) In the aspect of (1), the battery identification device further includes: a fixing mechanism configured to fix a posture of the tubular battery; wherein the sensor is configured to measure a magnetic field along an outer circumference of the battery while moving in a center axis direction of the battery when the posture of the battery is fixed by the fixing mechanism.

(5) In the aspect of (1), the wound product includes electrode tabs electrically connected to the electrodes, and the hardware processor recognizes positions of the electrode tabs based on a distribution in a circumferential direction of the battery of a magnetic-field component in the circumferential direction or a distribution in a longitudinal direction of the magnetic-field component in the circumferential direction.

(6) In the aspect of (1), the wound product includes electrode tabs electrically connected to the electrodes, and the hardware processor recognizes the number of electrode tabs based on an intensity of a magnetic-field component in a longitudinal direction of the battery or an intensity of the magnetic-field component in a direction perpendicular to the longitudinal direction.

(7) In the aspect of (1), the wound product includes electrode tabs electrically connected to the electrodes, and the hardware processor recognizes a length or a width of the electrode tabs based on a position at which a distribution of measured values at the time of charging and a distribution of measured values at the time of discharging of a magnetic-field component in a direction perpendicular to a longitudinal direction of the battery cross each other.

(8) According to another aspect of the present invention, there is provided a battery identification method of identifying a tubular battery including a wound product in which electrodes are wound, the battery identification method being performed by a battery identification device having a sensor and a rotating mechanism,, the battery identification method including: measuring, by the sensor, a magnetic field in the vicinity of a surface of the battery while moving relative to a side surface of the battery; rotating, by the rotating mechanism, the battery with an axis passing through both end surfaces of the tubular battery as a rotation axis; applying a current to the battery; measuring a magnetic field generated with application of the current; and acquiring a type of the battery which is determined by comparing the measurement result of the magnetic field with magnetic field information correlated with the type of battery, wherein the sensor measures the magnetic field while moving in a circumferential direction relative to the side surface of the battery using the rotating mechanism.

(9) According to another aspect of the present invention, there is provided a non-transitory storage medium storing a program, the program causing a battery identification device having a sensor and a rotating mechanism for identifying a tubular battery including a wound product in which electrodes are wound to perform: measuring, by the sensor, a magnetic field in the vicinity of a surface of the battery while moving relative to a side surface of the battery; rotating, by the rotating mechanism, the battery with an axis passing through both end surfaces of the tubular battery as a rotation axis; applying a current to the battery; measuring a magnetic field generated with application of the current; and acquiring a type of the battery which is determined by comparing the measurement result of the magnetic field with magnetic field information correlated with the type of battery, wherein the sensor measures the magnetic field while moving in a circumferential direction relative to the side surface of the battery using the rotating mechanism.

According to the aspects of (1) to (9), it is possible to nondestructively and noninvasively identify the type of battery without attaching an identification component thereto.

### BRIEF DESCRIPTION OF THE DRAWINGS

FIG. 1 is a diagram schematically illustrating the configuration of a battery cell.
FIG. 2 is a diagram schematically illustrating the configuration of a battery unit.
FIG. 3 is a diagram schematically illustrating an example of a configuration of a battery identification device.
FIG. 4 is a diagram illustrating an example of details of correlation information.
FIG. 5 is a diagram illustrating an example of a configuration for measuring magnetic field characteristics associated with an identification current in a target battery cell which is performed by the battery identification device.
FIG. 6 is a diagram illustrating an example of a configuration of a positive electrode 12P and a negative electrode 12N in a battery cell.
FIG. 7 is a (first) diagram illustrating an influence of a negative-electrode tab on magnetic field characteristics at the time of application of an identification current to a battery cell.
FIG. 8 is a (second) diagram illustrating an influence of a negative-electrode tab on magnetic field characteristics at the time of application of an identification current to a battery cell.
FIG. 9 is a diagram illustrating comparison between magnetic field characteristics at the time of application of an identification current to a battery cell with a first configuration and a battery cell with a second configuration (a longitudinal-direction component).
FIG. 10 is a diagram illustrating comparison between magnetic field characteristics at the time of application of an identification current to a battery cell with a first configuration and a battery cell with a second configuration (a circumferential-direction component).
FIG. 11 is a diagram illustrating comparison between magnetic field characteristics at the time of application of an identification current to a battery cell with a first configuration and a battery cell with a second configuration (a radial-direction component).
FIG. 12 is a diagram illustrating comparison between magnetic field characteristics at the time of application of an identification current to a battery cell with a first configuration and a battery cell with a second configuration (an absolute value of a combined vector of a longitudinal-direction component, a circumferential-direction component, and a radial-direction component).

### DETAILED DESCRIPTION OF THE INVENTION

Hereinafter, a battery identification device, a battery identification method, and a storage medium according to an embodiment of the present invention will be described with reference to the accompanying drawings.

In the following embodiment, a method of identifying the type of battery cell which is each individual battery cell in a battery unit including a plurality of battery cells will be described. In this embodiment, each individual battery cell is based on the premise of a cylindrical battery cell including a collector and a wound product in which a positive-electrode terminal is provided on one end surface and a negative-electrode terminal is provided on the other end surface. The battery cell according to this embodiment is an example of a "battery" in the claims. In the following embodiment, a cylindrical battery cell is described as an example of a tubular battery cell, but a battery identification method according to the embodiment can be applied to a tubular battery cell having a triangular pillar shape or a rectangular pillar shape in addition to a cylindrical pillar shape.

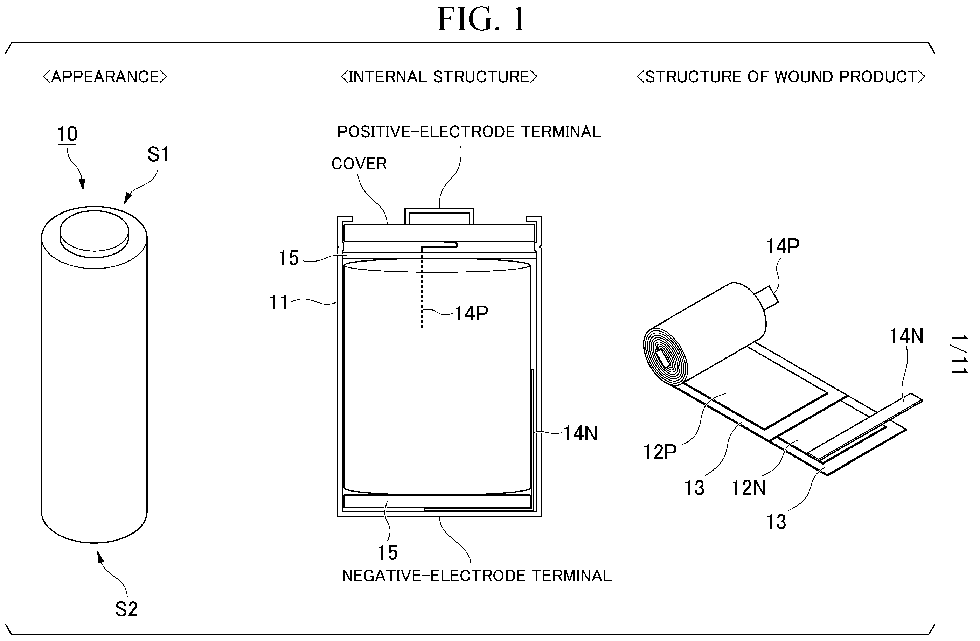

FIG. 1 is a diagram schematically illustrating the configuration of a battery cell. In FIG. 1, the left part illustrates the appearance of a battery cell 10 according to the embodiment, and the central part is a sectional view schematically illustrating an internal structure of the battery cell 10. The right part is a diagram illustrating a structure of a wound product in the battery cell 10. As illustrated in FIG. 1, the battery cell 10 has a cylindrical shape, and, for example, one end surface thereof is formed as a positive-electrode terminal S1, and the other end surface is formed as a negative-electrode terminal S2. The battery cell 10 has a configuration in which a wound product 15 in which a stacked body in which a positive electrode 12P and a negative electrode 12N are separated by a separator 13 is wound, a positive-electrode tab 14P provided on the positive electrode 12P, a negative-electrode tab 14N provided on the negative electrode 12N, and an insulator 16 for insulating the wound product 15, the positive-electrode terminal, and the negative electrode terminal from each other are accommodated in an outer can 11. The positive electrode 12P and the negative electrode 12N are immersed in an electrolyte (not illustrated) in a state in which they are separated from each other by the separator 13 and are wound. The positive-electrode tab 14P electrically connects the positive electrode 12P and the positive-electrode terminal S1, and the negative-electrode tab 14N electrically connects the negative electrode 12N and the negative-electrode terminal S2. The positive-electrode tab 14P is disposed at a winding start of the positive electrode 12P, and the negative-electrode tab 14N is disposed at a winding end of the negative electrode 12N. The wound product 15 is wound such that the negative electrode 12N faces outward.

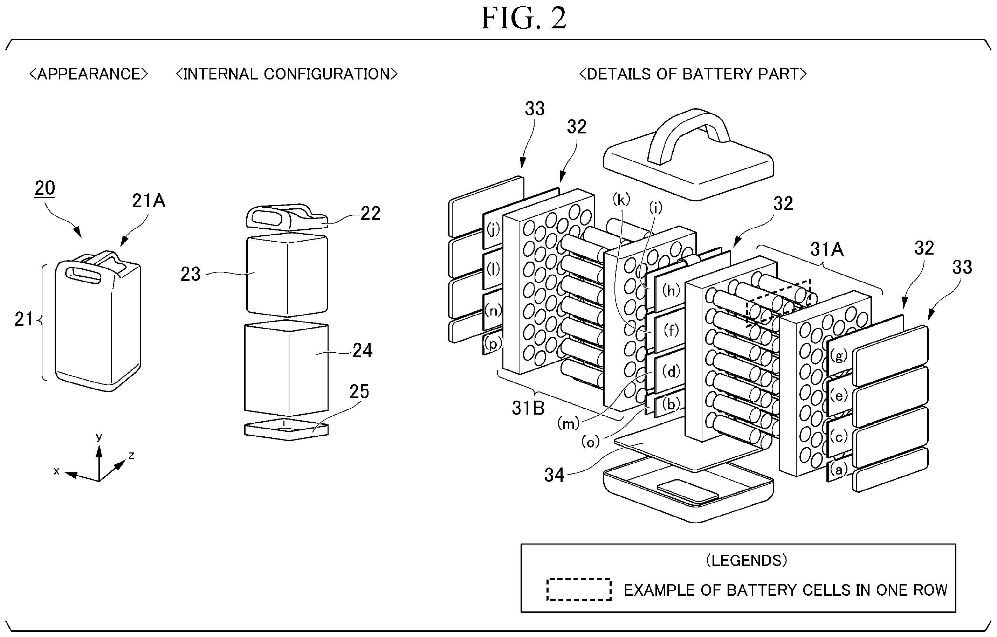

FIG. 2 is a diagram schematically illustrating the configuration of a battery unit. In FIG. 2, the left part illustrates an appearance of a battery unit 20 according to this embodiment, and the central part illustrates an internal configuration of the battery unit 20. As illustrated in FIG. 2, the battery unit 20 has a configuration in which a top case 22, a battery part 23, a side case 24, and a bottom case 25 are accommodated in a housing 21 with a grip 21A. A plurality of battery cells 10 are fixed to and accommodated in two cell holders 31A and 31B. In the battery unit 20, the battery cells 10 are arranged such that battery cells of two neighboring columns alternate in polarity column by column.

In the battery unit 20, a busbar 32 connecting the battery cells 10 in series is provided. The busbar 32 in the example illustrated in FIG. 2 includes sub-bars (a) to (p) to connect the battery cells 10 corresponding to a row (three battery cells) in series to the battery cells 10 in nearby columns. For example, one end sub-bar (a) of the busbar 32 is electrically connected to the positive-electrode terminal, and the other end sub-bar (p) is electrically connected to the negative-electrode terminal. With this configuration, the battery cells 10 in the rows are connected in series by the busbar 32 in the order of sub-bars (a) to (p). The sub-bars (h) and (i) of the busbar 32 are directly connected to each other, whereby a group of the battery cells 10 in the cell holder 31B is connected in series to a group of the battery cells 10 in the cell holder 31A. In the housing 21, a battery management unit (BMU) 34 having a function of managing the battery part 23 in addition to a heat-dissipation heat transfer sheet 33 installed on side surfaces is provided. In the battery unit 20, the plurality of battery cells 10 are arranged sideways on the bottom surface of the battery unit 20. In other words, the plurality of battery cells 10 are arranged such that a cylindrical axis thereof is parallel to the bottom surface of the battery unit 20.

The BMU 34 has, for example, a function of controlling charging or discharging of the battery part 23, a function of controlling a direction in which a current flows or a voltage value, a function of monitoring states of the battery cells 10, and an on/off control function of switching a battery circuit between an on state and an off state. The BMU 34 includes a storage unit for storing information required for various management functions or a communication unit for communicating with an external device.

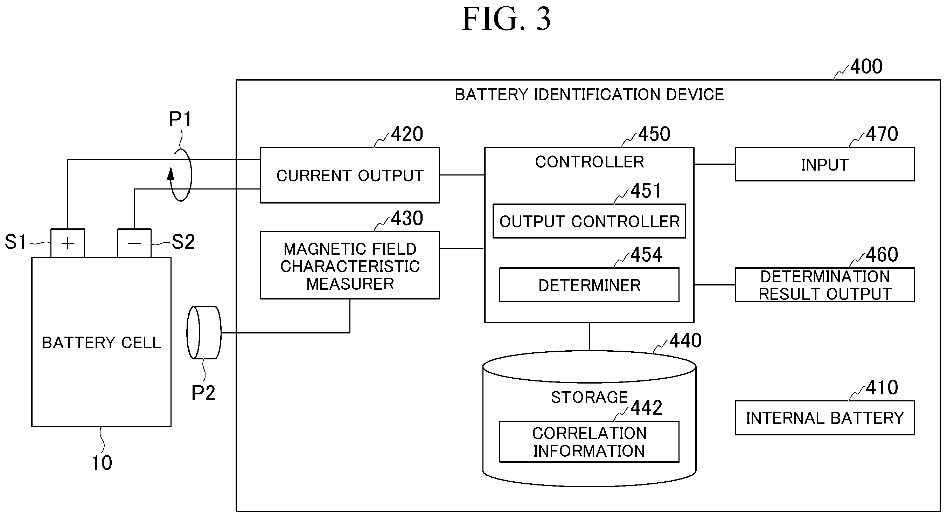

FIG. 3 is a diagram schematically illustrating an example of a configuration of a battery identification device 400 according to this embodiment. The battery identification device 400 is a device that identifies a type of the battery cell 10. The battery identification device 400 includes an internal battery 410, a current output 420, a magnetic field characteristics measurer 430, a storage 440, a controller 450, a determination result output 460, and an input 470. These constituents are realized, for example, by causing a hardware processor such as a central processing unit (CPU) to execute a program (software). Some or all of the constituents may be realized by hardware (a circuit unit including circuitry) such as a large-scale integration (LSI) circuit, an application-specific integrated circuit (ASIC), a field-programmable gate array (FPGA), or a graphics processing unit (GPU) or may be cooperatively realized by software and hardware. Here, the program may be stored in a storage device (a storage device including a non-transitory storage medium) such as a hard disk drive (HDD) or a flash memory in advance or may be stored in a detachable storage medium (a non-transitory storage medium) such as a DVD or a CD-ROM and installed by setting the storage medium into a drive device.

The internal battery 410 is a battery that supplies electric power required for operations of the battery identification device 400. The functional units of the battery identification device 400 can operate with electric power supplied from the internal battery 410. The internal battery 410 may be a battery or may be an interface that acquires electric power from another power supply.

The current output 420 is a current application circuit that is controlled to apply a specific current to the battery cell 10. A specific current is a current (hereinafter referred to as an "identification current") applied to the battery cell 10 for the purpose of identifying a battery type of the battery cell 10. The current output 420 applies a current with an intensity instructed by the controller 450 to the battery cell 10. The current output from the current output 420 is applied to the battery cell 10 via a probe P1.

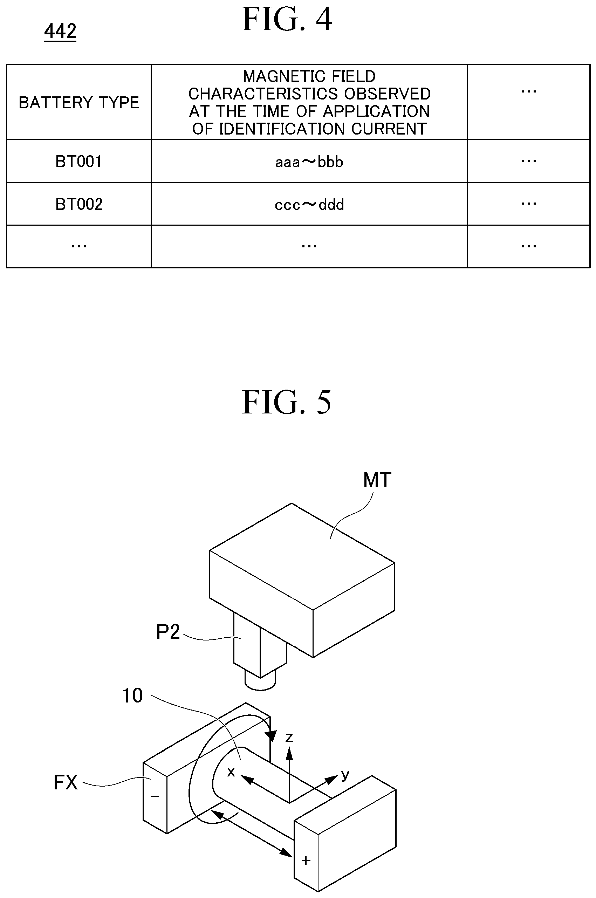

The magnetic field characteristics measurer 430 is a circuit that measures magnetic field characteristics of a measurement target based on a probe signal detected by a magnetic field measuring probe P2. The magnetic field detector P2 is, for example, a magnetic probe including a magnetic element therein or a magnetic element array board in which a plurality of magnetic elements are arranged. The magnetic elements in the magnetic element array board may be arranged at regular intervals or may be arranged at irregular intervals. Each magnetic element may be a single-axis measuring element or may be a three-axis measuring element. It is preferable that a single-axis measuring element be disposed such that a magneto-sensitive surface thereof faces a circumferential direction of the battery cell (a y-axis direction in FIG. 5). This is for easily acquiring a magnetic field distribution in which direction arrangement of a battery cell 10 and a presence position of a collector tab are reflected by causing a macro current of the battery cell 10 and a current flowing in the collector tab to orthogonally cross the magneto-sensitive surface. Each magnetic element may be an analog element or may be a digital element. Each magnetic element may be, for example, a Hall element, a magnetoresistance element such as an anisotropic magnetoresistance effect (AMR) element, a giant magnetoresistance effect (GMR) element, or a tunnel magnetoresistance effect (TMR) element, a magneto-impedance element such as a magneto-impedance (MI) element, a flux gate, or a thin-film magnetic element based on an anomalous Hall effect using a topological magnetic substance. When an alternating current flows in a measurement target, a pickup coil may be used as a magnetic element. A range in which a magnetic field is detected by the magnetic field detector P2 may be the whole measuring surface of the battery unit 20 or an arbitrary part thereof as long as information sufficient to identify a battery type can be acquired. The magnetic element array board may have a size covering the whole measuring range of the measuring surface of the battery unit 20 or may scan the measuring surface with a size covering a part of the measuring range. More specifically, the battery identification device 400 measures magnetic field characteristics while scanning the vicinity of the surface of the battery cell 10 with the probe P2. A measuring position or a measuring timing of magnetic field characteristics or the like is assumed to be appropriately controlled by the controller 450. The magnetic field characteristics measurer 430 outputs a measured value of the magnetic field characteristics acquired for the battery cell 10 to the controller 450.

The storage 440 is configured, for example, using a magnetic storage device such as a hard disk drive (HDD) or a semiconductor storage device such as a solid-state drive (SSD) or configured as a database (DB) in a cloud. The storage 440 provides a storage area for storing various types of information of the operations of the battery identification device 400. Correlation information 442 on the battery cell 10 is stored in advance in the storage 440. The correlation information 442 is information in which at least magnetic characteristics which are observed when an identification current is applied to the battery cell 10 are correlated with a type (a battery type) of the battery cell 10 (see FIG. 4). For example, the correlation information 442 can be generated based on a result of a test for measuring magnetic field characteristics using an identification current for each battery type to be identified. In addition to the correlation information 442, for example, a measurement result of magnetic field characteristics of the battery cell 10, a determination result of a battery type, setting information of a current applied to the battery cell 10, various programs for realizing the controller 450, and the like may be stored in the storage 440.

The controller 450 controls the constituents of the battery identification device 400 to identify a battery type of a target battery cell 10. In the following description, a battery cell 10 of which a battery type is to be identified is referred to as a target battery cell 10. The controller 450 includes, for example, an output controller 451 and a determiner 454. The output controller 451 has a function of applying an identification current to a target battery cell 10 by controlling an output intensity of the current output 420. For example, the output controller 451 may apply an alternating current varying in a sinusoidal shape to the target battery cell 10 by continuously changing the output intensity of the current output 420. The output controller 451 may apply a direct-current varying in a rectangular wave shape to the target battery cell 10 by changing the output intensity of the current output 420 at predetermined timings.

The output controller 451 may be configured to detect connection of the target battery cell 10 to the battery identification device 400 and to start application of an identification current to the target battery cell 10. The battery identification device 400 includes an input device such as a mouse or a keyboard, the output controller 451 may be configured to start application of an identification current to the target battery cell 10 in response to a user's input operation.

The determiner 454 determines the battery type of the target battery cell 10 based on a value of the magnetic field characteristics measured from the target battery cell 10. More specifically, the determiner 454 determines the battery type corresponding to the value of the magnetic field characteristics measured from the target battery cell 10 based on the correlation information 442. For example, in the example illustrated in FIG. 4, when the measured value of the magnetic field characteristics is in a range of "aaa to bbb," the determiner 454 can determine that the battery type of the target battery cell 10 is "BT001." The determiner 454 outputs the determination result of the battery type to the determination result output 460. The determiner 454 is configured in cloud. The storage 440 and the determiner 454 are an example of a "reader." When at least one of the storage 440 and the determiner 454 is in cloud, the battery identification device 400 may have a function of communicating with the cloud and acquiring (reading) at least one of a prescribed value and information on identity from the cloud (may include a reader). The determiner 454 is an example of an "acquirer."

The correlation information 442 may be configured to store a feature quantity acquired based on magnetic field characteristics in correlation with the battery type instead of/in addition to the magnetic field characteristics. In this case, the determiner 454 may be configured to determine the battery type of the target battery cell 10 based on the feature quantity acquired based on the measured value instead of/in addition to the measured value of the magnetic field characteristics acquired from the target battery cell 10. The feature quantity may have a value acquired for each individual measured value or may be a statistical value acquired for a plurality of measured values.

The determination result output 460 outputs the determination result of the battery type output from the determiner 454 in a predetermined form. For example, the determination result output 460 may display the determination result on a display device such as a liquid crystal display or an organic electroluminescence (EL) display. For example, the determination result output 460 may transmit the determination result to another communication device via a wired or wireless communication interface. The determination result output 460 may output voice indicating details of the determination result from a voice output device such as a speaker.

The input 470 has a function of inputting information to the battery identification device 400. For example, the input 470 may be configured to receive an information input operation via an input device such as a mouse or a keyboard. The input 470 may be configured to input (receive) information by communication via a wired or wireless communication interface. The input 470 outputs the input information to the controller 450.

FIG. 5 is a diagram illustrating an example of a configuration for measuring magnetic field characteristics associated with an identification current in a target battery cell 10 which is performed by the battery identification device 400. As described above, a measuring position or timing or the like in measuring magnetic field characteristics of a target battery cell 10 at the time of application of an identification current is controlled by the controller 450. The measuring configuration illustrated in FIG. 5 is to measure magnetic field characteristics on the whole surface of the target battery cell 10 by scanning the surface in a longitudinal direction (which is a center axis direction of a cylinder and an x-axis direction in the drawing) of the target battery cell 10 while moving the probe P2 in the longitudinal direction and scanning the cylindrical surface in a circumferential direction while rotating the target battery cell 10 with the center axis of the cylinder as a rotation axis. In this example, the magnetic field characteristics measurer 430 of the battery identification device 400 may include a fixing mechanism FX for rotatably fixing the target battery cell 10 to predetermined position and posture and a driving mechanism MT for the probe P2 in parallel to the rotation axis of the target battery cell 10.

The battery identification device 400 may have a measuring configuration other than the measuring configuration illustrated in FIG. 5 as long as it can cover the whole surface of the target battery cell 10 and measure magnetic field characteristics. For example, the magnetic field characteristics measurer 430 may include a driving mechanism for moving the target battery cell 10 in the longitudinal direction to scan the target battery cell 10 in the longitudinal direction or may include a driving mechanism for rotating the probe P2 in the circumferential direction with the center axis of the target battery cell 10 as a rotation axis to scan the target battery cell 10 in the circumferential direction.

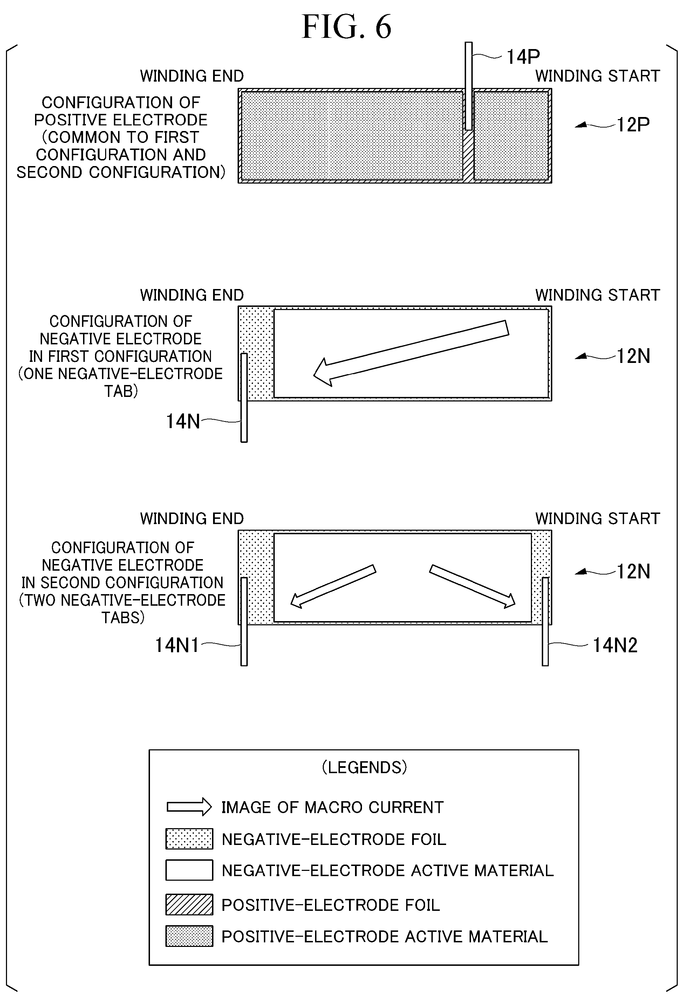

FIG. 6 is a diagram illustrating an example of a configuration of a positive electrode 12P and the negative electrode 12N in a battery cell 10. As described above with reference to in FIG. 1, a positive-electrode tab 14P electrically connecting the positive electrode 12P and a positive-electrode terminal and a negative-electrode tab 14N electrically connecting the negative electrode 12N and a negative-electrode terminal are provided in a battery cell 10. As illustrated in FIG. 1, a rectangular panel-shaped metal member is used as the positive-electrode tab 14P and the negative-electrode tab 14N. The positive electrode 12P is formed by applying a positive-electrode active material onto a positive-electrode foil, and the negative electrode 12N is formed by applying a negative-electrode active material onto a negative-electrode foil. The electrodes provided in the battery cell 10 can be formed in various configurations according to design, and FIG. 6 illustrates a first configuration including one negative-electrode tab 14N and a second configuration including two negative-electrode tabs 14N1 and 14N2. As illustrated in FIG. 6, the configuration of the positive electrode 12P is the same in both the first configuration and the second configuration. The negative-electrode tab 14N is attached to a part which is an end of a negative-electrode foil and to which a negative-electrode active material is not applied. On the other hand, the positive-electrode tab 14P is attached to a part which is an intermediate part between a winding start and a winding end of a positive-electrode foil and to which a positive-electrode active material is not applied. In the first configuration, an active material can be applied to a space in which the negative-electrode tab 14N2 is disposed in the second configuration, and thus there is a merit that the capacity can be increased as much in comparison with the second configuration. On the other hand, in the second configuration, a current is enlarged to two flow channels, and thus there is a merit that an output can be increased as a whole.

As illustrated in FIG. 6, a current flowing in the negative electrode in the first configuration is an image of only one flow channel directed to the negative-electrode tab 14N from a macro point of view. On the other hand, the current flowing in the negative electrode in the second configuration is distributed to a first flow channel directed to the negative-electrode tab 14N1 and a second flow channel directed to the negative-electrode tab 14N2 from a macro point of view. Accordingly, the current value flowing in one negative-electrode tab is larger in the first configuration than in the second configuration.

In both the first configuration and the second configuration, the positive-electrode tab is disposed at a winding start of the wound product (a central part of the cylinder), and the negative-electrode tab is disposed at a winding end of the wound product (an outer circumference of the cylinder). Accordingly, when magnetic field characteristics in the vicinity of the surface of the battery cell 10 are measured, an influence of arrangement of the negative-electrode tab is more greatly reflected in the measurement result.

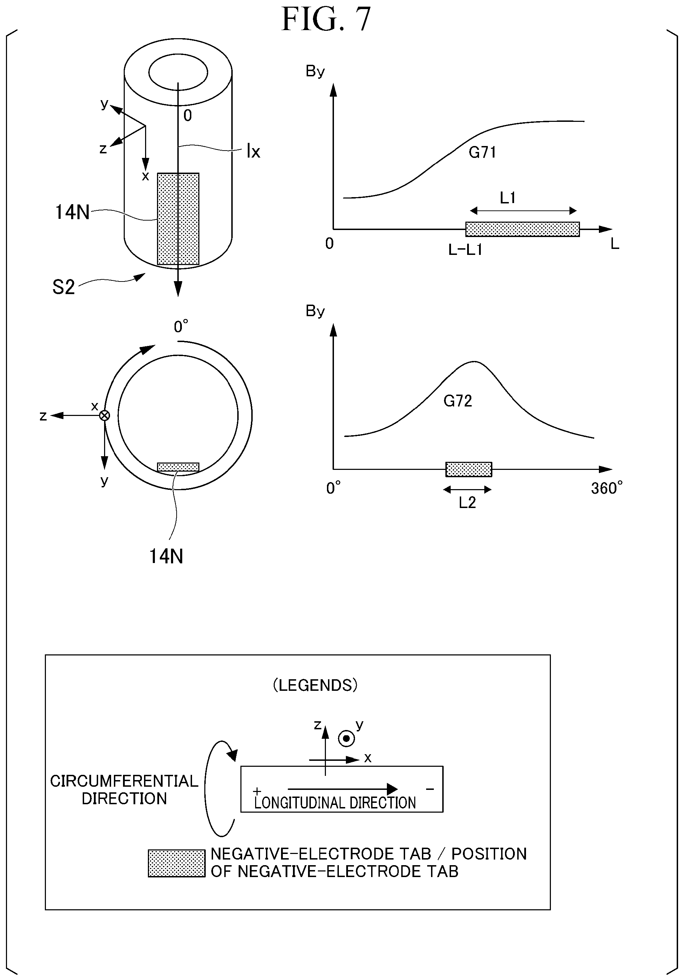

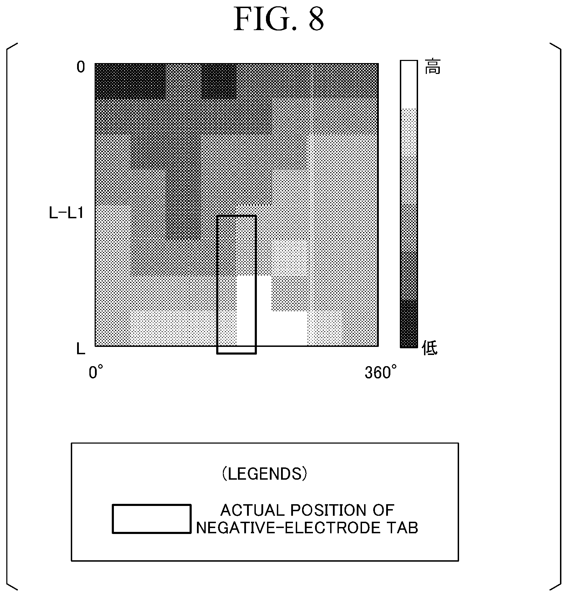

FIGS. 7 and 8 are diagrams illustrating an influence of a negative-electrode tab on magnetic field characteristics of a battery cell 10 at the time of application of an identification current. FIG. 7 illustrates arrangement of the negative-electrode tab 14N in the battery cell 10. As illustrated in FIG. 7, the negative-electrode tab 14N is disposed along a cylindrical inner surface of the battery cell 10, for example, such that a longitudinal direction thereof is identical to the longitudinal direction of the battery cell 10. The negative-electrode tab 14N is disposed, for example, at a position biased to the negative-electrode terminal S2 of the battery cell 10. In the example illustrated in FIG. 7, the negative-electrode tab 14N (of which a length in the longitudinal direction is L1 and a length in the short direction is L2) is disposed in a range of L-L1 to L in the longitudinal direction (the x-axis direction) of the battery cell 10 (of which a length in the longitudinal direction is L) and is installed at a position of 180° in the circumferential direction of the battery cell 10. When a magnetic field in the longitudinal direction (the x-axis direction) is measured at a position (180°) at which the negative-electrode tab 14N is present in the circumferential direction of the battery cell 10, a magnetic field generated due to a current Ix flowing in the longitudinal direction (the x-axis direction) in the negative-electrode tab 14N has a large influence, and, for example, the distribution indicated by graph G71 is obtained as the distribution in the longitudinal direction of a magnetic-field component (By) in the circumferential direction (the y-axis direction) on the surface of the battery cell 10. In this case, when a magnetic field in the circumferential direction (the y-axis direction) is measured at a position (in a range of L-L1 to L in which the negative-electrode tab 14N is present in the longitudinal direction of the battery cell 10, for example, a distribution indicated by graph G72 is obtained as the distribution in the circumferential direction of a magnetic-field component (By) in the circumferential direction (the y-axis direction) on the surface of the battery cell 10.

In this case, as indicated by graph G71, it can be seen that an intensity of the magnetic field at a position at which the negative-electrode tab 14N is disposed increases in both the longitudinal direction and the circumferential direction of the battery cell 10. More specifically, it can be seen that the intensity of the magnetic field in the longitudinal direction increases in a range with a length L1 in the longitudinal direction of the negative-electrode tab 14N and the intensity of the magnetic field in the circumferential direction increases in a range with a length L2 in the short direction of the negative-electrode tab 14N. Accordingly, it is possible to identify the position of the negative-electrode tab 14N by extracting such features from the measurement result of the magnetic field characteristics. FIG. 8 is a graph indicating a distribution of magnetic field characteristics in which a distribution in the longitudinal direction is set as the vertical axis and a distribution in the circumferential direction is set as the horizontal axis. It can also be recognized from FIG. 8 that the negative-electrode tab 14N is present in the vicinity of 180° in the horizontal axis and in the vicinity of L-L1 to L in the vertical axis. This tendency is the same for the distribution of a magnetic-field component Bx in the longitudinal direction of the battery cell 10 and the distribution of a magnetic-field component Bz in the radial direction, and the tendency is more remarkable than in the component By in the circumferential direction.

In this way, when an identification current is applied to a cylindrical battery cell 10, the battery identification device 400 can identify a position of a tab in the battery cell 10 by measuring magnetic field characteristics in the longitudinal direction and the circumferential direction of the battery cell 10 and analyzing a magnetic field intensity distribution. More specifically, the determiner 454 can estimate that a range in which the measurement results are greater than predetermined threshold values is the position of the tab by comparing the measurement results of magnetic field characteristics in the longitudinal direction and the circumferential direction with the threshold values. When the position of the tab can be identified, the battery identification device 400 can adjust the measurement results to a standard based on the recognized position of the tab. When the measurement results can be adjusted to the standard, the battery identification device 400 can more accurately identify measured values of the magnetic field characteristics to be used and determine a battery type, and thus it is possible to more accurately determine the battery type of a cylindrical battery cell 10.

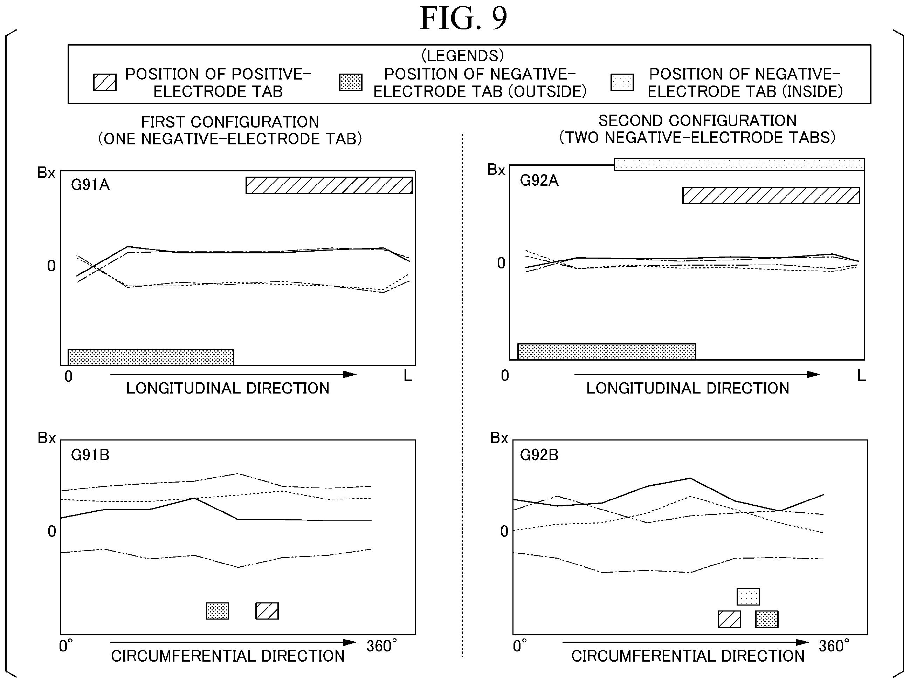

FIGS. 9 to 12 are diagrams illustrating comparison between magnetic field characteristics at the time of application of an identification current to a battery cell 10 with the first configuration (which includes one negative-electrode tab) and a battery cell 10 with the second configuration (which includes two negative-electrode tabs). In FIGS. 9 to 12, a plurality of sequences in a graph illustrated in the upper part indicate sequences obtained by measuring magnetic field characteristics at a plurality of points at which angles in the circumferential direction are different, and a plurality of sequences in a graph illustrated in the lower part indicate sequences obtained by measuring magnetic field characteristics at a plurality of points at which positions in the longitudinal direction are different. In FIGS. 9 to 12, the legends indicate positions (present ranges) of a positive-electrode tab and a negative-electrode tab in the horizontal axis.

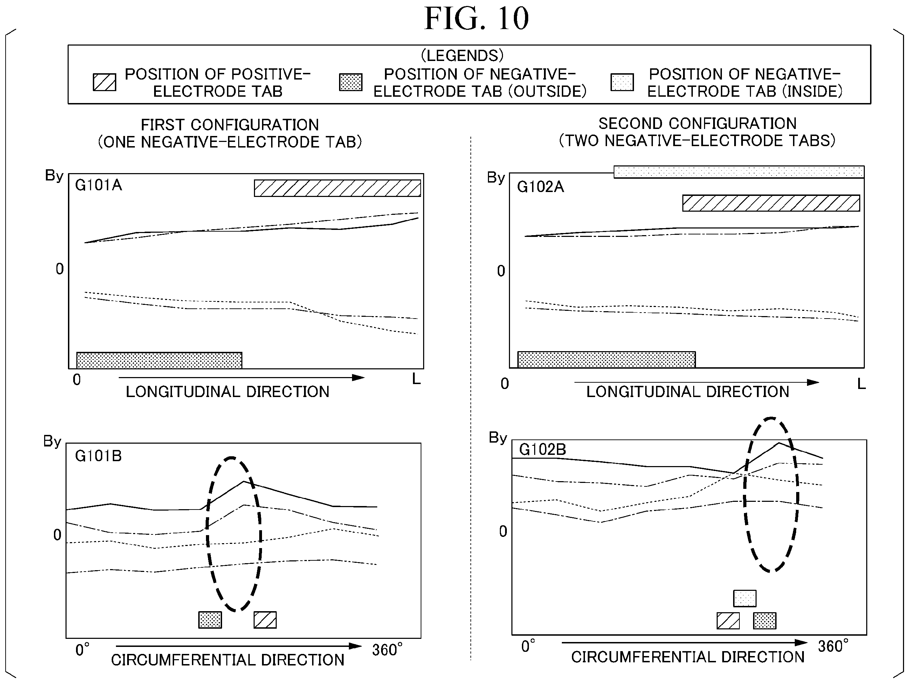

First, graph G91A in FIG. 9 indicates a result obtained by measuring a magnetic-field component Bx in the longitudinal direction (the x-axis direction) in a battery cell 10 with the first configuration in the longitudinal direction. The horizontal axis of graph G91A indicates a position in the longitudinal direction, and the sequences indicate sequences in which positions (angles) in the circumferential direction at which measurement is performed are different. Graph G91B indicates a result obtained by measuring a magnetic-field component Bx in the longitudinal direction (the x-axis direction) in a battery cell 10 with the first configuration in the circumferential direction. The horizontal axis of graph G91B indicates a position (angle) in the circumferential direction, and the sequences indicate sequences in which positions in the longitudinal direction at which measurement is performed are different. Graph G92A indicates a result obtained by performing the same measurement as in graph G91A on a battery cell 10 with the second configuration. Graph G92B indicates a result obtained by performing the same measurement as in graph G92A on a battery cell 10 with the second configuration. In graphs G91A and G92A, there are two sequence groups, one sequence group indicates measurement results at the time of charging due to an identification current, and the other sequence group indicates measurement results at the time of discharging due to the identification current (the same is true of FIGS. 10 to 12).

Then, graph G101A in FIG. 10 indicates a result obtained by measuring a magnetic-field component By in the circumferential direction (the y-axis direction) in a battery cell 10 with the first configuration in the longitudinal direction. The horizontal axis of graph G101A indicates a position in the longitudinal direction, and the sequences indicate sequences in which positions (angles) in the circumferential direction at which measurement is performed are different. Graph G101B indicates a result obtained by measuring a magnetic-field component By in the circumferential direction (the y-axis direction) in a battery cell 10 with the first configuration in the circumferential direction. The horizontal axis of graph G101B indicates a position (angle) in the circumferential direction, and the sequences indicate sequences in which positions in the longitudinal direction at which measurement is performed are different. Graph G102A indicates a result obtained by performing the same measurement as in graph G101A on a battery cell 10 with the second configuration. Graph G102B indicates a result obtained by performing the same measurement as in graph G102A on a battery cell 10 with the second configuration.

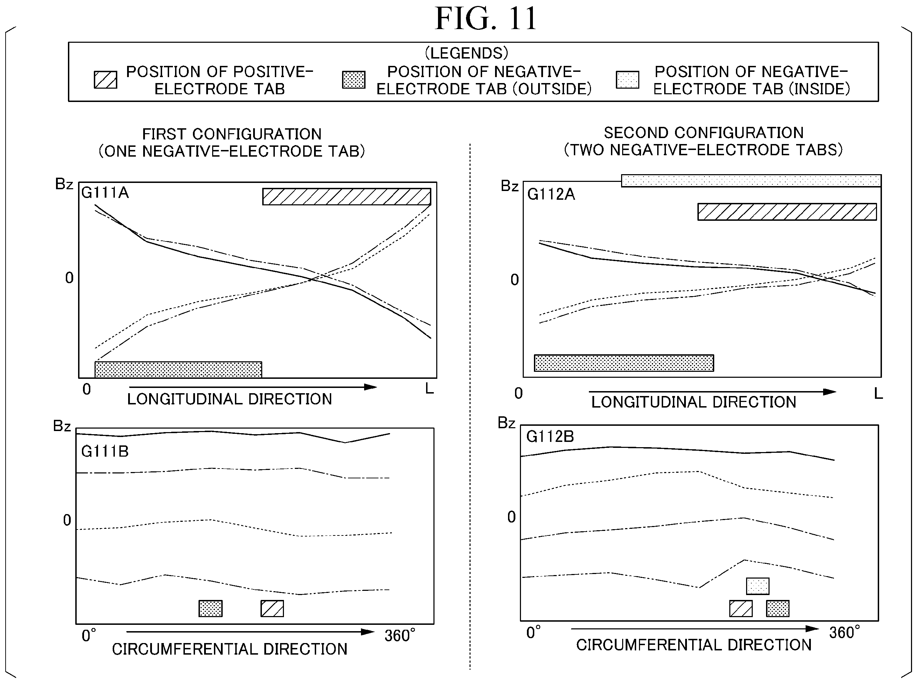

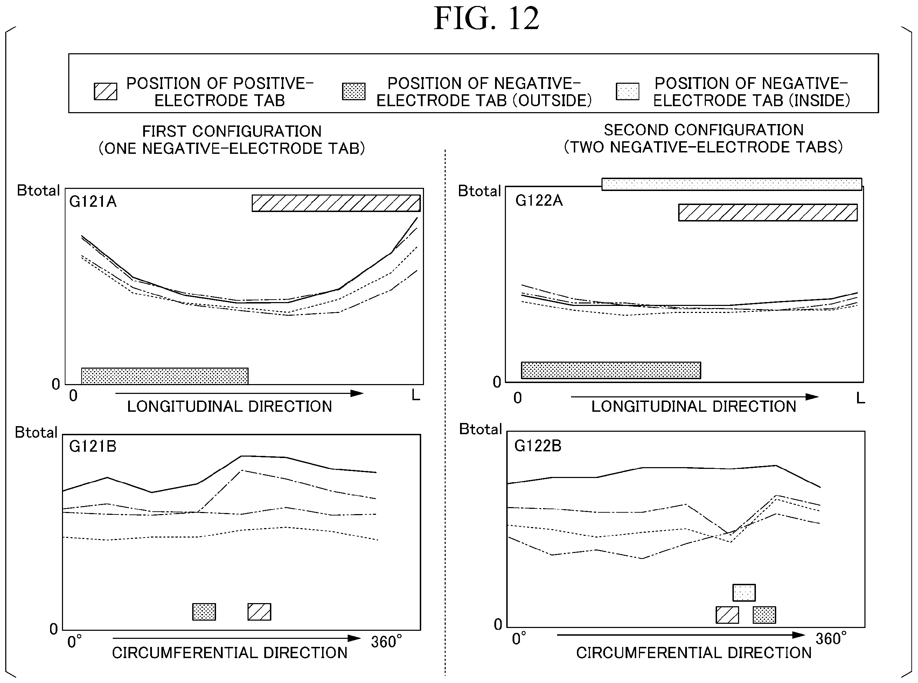

Then, graph G111A in FIG. 11 indicates a result obtained by measuring a magnetic-field component Bz in the radial direction (the z-axis direction) in a battery cell 10 with the first configuration in the longitudinal direction. The horizontal axis of graph G111A indicates a position in the longitudinal direction, and the sequences indicate sequences in which positions (angles) in the circumferential direction at which measurement is performed are different. Graph G111B indicates a result obtained by measuring a magnetic-field component Bz in the radial direction (the z-axis direction) in a battery cell 10 with the first configuration in the circumferential direction. The horizontal axis of graph G111B indicates a position (angle) in the circumferential direction, and the sequences indicate sequences in which positions in the longitudinal direction at which measurement is performed are different. Graph G112A indicates a result obtained by performing the same measurement as in graph G111A on a battery cell 10 with the second configuration. Graph G112B indicates a result obtained by performing the same measurement as in graph G111B on a battery cell 10 with the second configuration. In FIG. 12, the measurement results Bx, By, and Bz illustrated in FIG. 9 to 11 are converted to an absolute value of a combined vector thereof.

Through comparison of the magnetic-field components Bx and Bz between the battery cell 10 with the first configuration and the battery cell 10 with the second configuration, it can be seen that change tendencies are similar but absolute values thereof are greatly different (see FIGS. 9, 11, and 12). More specifically, it can be seen that the absolute value of the magnetic-field component in the battery cell 10 with the first configuration (which includes one negative-electrode tab) is greater than that in the battery cell 10 with the second configuration (which includes two negative-electrode tabs). Therefore, the battery identification device 400 according to this embodiment determines whether the target battery cell 10 has the first configuration or the second configuration by comparing the magnitudes of the absolute values of the magnetic-field component Bx or/and Bz with predetermined reference values. In this case, reference values may be managed in correlation with battery types in the correlation information 442. The reference values may have a width, and separate reference values may be set for the magnetic-field component Bx and the magnetic-field component Bz. The battery identification device 400 may determine whether the absolute values of the magnetic-field component Bx or the magnetic-field component Bz at a plurality of positions in the longitudinal direction or the circumferential direction match the reference values.

Since the values of the magnetic-field components Bx and Bz may vary depending on the measuring positions, the determiner 454 preferably adjusts the reference positions of the measurement results based on the position of the negative-electrode tab (see FIG. 7) identified based on the distribution of the magnetic-field component By and compares the measurement results with the threshold values. By comparing the measurement results with the threshold values with the reference positions adjusted in this way, the determiner 454 can more accurately determine a battery type of a target battery cell 10. The determiner 454 may determine whether the measurement results match the reference value based on the magnetic-field component Bx, may determine whether the measurement results match the reference value based on the magnetic-field component Bz, or may comprehensively determine whether the measurement results match the reference value based on a combination of both determination results. For example, when the determination result based on the magnetic-field component Bx matches the determination result based on the magnetic-field component Bz, the determiner 454 may confirm the determination result. For example, when both determination results do not match, the determiner 454 may be configured to employ the determination result with higher priority or to employ the determination result with a larger separation from the reference value (that is, with higher reliability of the determination result) based on predetermined priority.

When the magnetic-field component Bz is compared between the battery cell 10 with the first configuration and the battery cell 10 with the second configuration, it can be seen that a position at which the measurement result at the time of charging and the measurement result at the time of discharging cross each other (substantially zero-cross) is greatly different (see FIG. 11). More specifically, it can be seen that the crossing occurs at a position more biased to the negative-electrode terminal in the battery cell 10 with the first configuration (which includes one negative-electrode tab) than in the battery cell 10 with the second configuration (which includes two negative-electrode tabs). For example, the crossing occurs at a position a on the horizontal axis in graph G111A, and the crossing occurs at a position b (>a) in graph G112A. More specifically, when the length of the negative-electrode tab is short, it is considered that a current flowing into the tab is concentrated, a slope of the measurement result of graph G111A becomes steep, and the crossing point is biased to the negative-electrode terminal. Therefore, the battery identification device 400 according to this embodiment can identify the length of the negative-electrode tab by identifying the position at which the distribution of the magnetic-field component Bz at the time of charging and the distribution of the magnetic-field component Bz at the time of discharging cross each other. It may be conceivable that the longitudinal direction and the width direction be exchanged in arrangement of the negative-electrode tab according to variation of the internal configuration of the battery cell 10. In this case, it is also possible to recognize a difference in configuration with the magnitude of the width using the same method.

More specifically, the determiner 454 identifies the position at which the measurement result of the magnetic-field component Bz at the time of charging and the measurement result of the magnetic-field component Bz at the time of discharging cross each other and determines whether the position matches the reference value. For example, the determiner 454 may determine that the battery cell has the first configuration when the identified position is less than the reference value and determine that the battery cell has the second configuration when the identified position is equal to or greater than the reference value. The determiner 454 may identify the width of the negative-electrode tab (indicated by L2 in FIG. 7) based on the measurement result of the magnetic-field component By. The width of the negative-electrode tab identified in this way may be used as a feature quantity.

With the aforementioned battery identification device 400 according to the embodiment, it is possible to identify a battery type of a target battery cell 10 by applying an identification current to the target battery cell 10 and measuring magnetic field characteristics in the vicinity of the surface. For example, the battery identification device 400 can recognize a position of a negative-electrode tab in the target battery cell 10 from the measurement result of the magnetic-field component By. For example, the battery identification device 400 can recognize the number of negative-electrode tabs (a tab configuration) of the target battery cell 10 from the measurement results of the magnetic-field components Bx and Bz. For example, the battery identification device 400 can recognize the length of the negative-electrode tab in the target battery cell 10 from the measurement results of the magnetic-field component Bz at the time of charging and at the time of discharging. The battery identification device 400 can identify the battery type of the target battery cell 10 from each of the recognition results or from a combination of the recognition results. The battery identification device 400 may be configured to recognize features other than the positions, the number, and the length of the negative-electrode tabs in the target battery cell 10 based on arbitrary feature quantities based on the magnetic field characteristics and to identify the battery type based on a combination of the recognition results. With this configuration, the battery identification device 400 according to the embodiment can nondestructively and noninvasively identify the type of battery without attaching an identification component.

### <Modified examples>

With the battery identification device 400 according to the aforementioned embodiment, it is also possible to identify a battery type of a battery (or a battery cell) in which an IC chip or the like that can output an identification signal is not mounted. Accordingly, it is not necessary to mount an IC chip in a battery, and thus it is possible to solve a problem of a battery due to an interface or durability of the IC chip.

The battery unit 20 described above in the embodiment is assumed to be mainly used for a vehicle, but the present invention is not limited thereto. The battery identification device 400 may be configured to determine a battery type of a so-called mobile power pack (MPP) which is a detachable portable battery which can be used as a power of a small electric mobile vehicle or a household power source. The MPP battery identification device 400 may be provided in a battery charging device or a battery returning device (a so-called battery exchanger (BEX)) that can recover and charge a used MPP and re-lend a charged MPP. The battery identification device 400 may be configured as a unified body with such an MPP or the BEX or may be configured as a separate body.

In the aforementioned embodiment, the battery identification device 400 identifies a battery type based on magnetic field characteristics which are observed when an identification current is applied to a battery cell 10. With this measurement of magnetic field characteristics based on application of an identification current, there is a merit that identification accuracy can be secured by applying a current for generating a magnetic field which is not embedded in noise of the terrestrial magnetism or the ambient magnetic field. On the other hand, when a current value applied to a battery cell 10 is monitored, an intensity of an observed magnetic field can be considered to be proportional to the applied current value, and thus the measured intensity of the magnetic field can be converted to a standardized magnetic-field intensity without depending on the current value by dividing the measured intensity of the magnetic field by the current value. The battery identification device 400 may be configured to store a correlation of the standardized magnetic-field intensity with a battery type as correlation information. In this case, the battery identification device 400 can identify a battery type by converting the feature quantity which is observed by applying an arbitrary current to a target battery cell 10 to the standardized magnetic-field intensity and comparing the standardized magnetic-field intensity with the correlation information. In this way, whether the battery identification device 400 is to apply an identification current to a battery cell 10 or to apply an arbitrary current thereto may be appropriately selected according to nature or characteristics of an identification target, identification purpose or usage, or the like.

Since a battery configuration is symmetric in the concepts of a positive electrode and a negative electrode, the battery cell 10, the battery unit 20, and the battery identification device 400 may have reverse configurations in view of conceptual symmetry of a positive electrode and a negative electrode.

## Claims

1. A battery identification device for identifying a tubular battery including a wound product in which electrodes are wound, the battery identification device comprising:
a sensor configured to measure a magnetic field in the vicinity of a surface of the battery while moving relative to a side surface of the battery;
a rotating mechanism configured to rotate the battery with an axis passing through both end surfaces of the tubular battery as a rotation axis;
a storage device storing a program; and
a hardware processor,
wherein the hardware processor executes the program stored in the storage device to perform:
applying a current to the battery;
measuring a magnetic field generated with application of the current; and
acquiring a type of the battery which is determined by comparing the measurement result of the magnetic field with magnetic field information correlated with a type of battery,
wherein the sensor measures the magnetic field while moving in a circumferential direction relative to the side surface of the battery using the rotating mechanism.

2. The battery identification device according to claim 1, wherein the rotation axis passes through the center of one end surface of the battery and the center of the other end surface of the battery.

3. The battery identification device according to claim 1, wherein the sensor measures the magnetic field while moving parallel to the rotation axis.

4. The battery identification device according to claim 1, further comprising:
a fixing mechanism configured to fix a posture of the tubular battery, wherein
the sensor is configured to measure a magnetic field along an outer circumference of the battery while moving in a center axis direction of the battery when the posture of the battery is fixed by the fixing mechanism.

5. The battery identification device according to claim 1, wherein the wound product includes electrode tabs electrically connected to the electrodes, and
wherein the hardware processor recognizes positions of the electrode tabs based on a distribution in a circumferential direction of the battery of a magnetic-field component in the circumferential direction or a distribution in a longitudinal direction of the magnetic-field component in the circumferential direction.

6. The battery identification device according to claim 1, wherein the wound product includes electrode tabs electrically connected to the electrodes, and
wherein the hardware processor recognizes the number of electrode tabs based on an intensity of a magnetic-field component in a longitudinal direction of the battery or an intensity of the magnetic-field component in a direction perpendicular to the longitudinal direction.

7. The battery identification device according to claim 1, wherein the wound product includes electrode tabs electrically connected to the electrodes, and
wherein the hardware processor recognizes a length or a width of the electrode tabs based on a position at which a distribution of measured values at the time of charging and a distribution of measured values at the time of discharging of a magnetic-field component in a direction perpendicular to a longitudinal direction of the battery cross each other.

8. A battery identification method of identifying a tubular battery including a wound product in which electrodes are wound, the battery identification method being performed by a battery identification device having a sensor and a rotating mechanism, the battery identification method comprising:
measuring, by the sensor, a magnetic field in the vicinity of a surface of the battery while moving relative to a side surface of the battery;
rotating, by the rotating mechanism, the battery with an axis passing through both end surfaces of the tubular battery as a rotation axis;
applying a current to the battery;
measuring a magnetic field generated with application of the current; and
acquiring a type of the battery which is determined by comparing the measurement result of the magnetic field with magnetic field information correlated with a type of battery,
wherein the sensor measures the magnetic field while moving in a circumferential direction relative to the side surface of the battery using the rotating mechanism.

9. A non-transitory storage medium storing a program, the program causing a battery identification device having a sensor and a rotating mechanism for identifying a tubular battery including a wound product in which electrodes are wound to perform:
measuring, by the sensor, a magnetic field in the vicinity of a surface of the battery while moving relative to a side surface of the battery;
rotating, by the rotating mechanism, the battery with an axis passing through both end surfaces of the tubular battery as a rotation axis;
applying a current to the battery;
measuring a magnetic field generated with application of the current; and
acquiring a type of the battery which is determined by comparing the measurement result of the magnetic field with magnetic field information correlated with a type of battery,
wherein the sensor measures the magnetic field while moving in a circumferential direction relative to the side surface of the battery using the rotating mechanism.

## Patentansprüche

1. Eine Batterie-Identifizierungsvorrichtung zum Identifizieren einer röhrenförmigen Batterie, die ein gewickeltes Produkt enthält, in dem Elektroden gewickelt sind, wobei die Batterie-Identifizierungsvorrichtung aufweist:
einen Sensor, der so ausgebildet ist, dass er in der Nähe einer Oberfläche der Batterie ein Magnetfeld misst, während er sich relativ zu einer Seitenfläche der Batterie bewegt;
einen Drehmechanismus, der so ausgebildet ist, dass er die Batterie um eine durch beide Endflächen der röhrenförmigen Batterie als Drehachse verlaufenden Achse dreht;
eine Speichervorrichtung, die ein Programm speichert; und
einen Hardwareprozessor,
wobei der Hardwareprozessor das in der Speichervorrichtung gespeicherte Programm ausführt, um Folgendes durchzuführen:
Anlegen eines Stroms an die Batterie;
Messen eines durch das Anlegen des Stroms erzeugten Magnetfelds; und
Erfassen eines Batterie-Typs, der durch Vergleichen des Ergebnisses der Magnetfeldmessung mit Magnetfeldinformation, welche mit einem Batterie-Typ korreliert, bestimmt wird,
wobei der Sensor das Magnetfeld misst, während er sich unter Verwendung des Drehmechanismus relativ zur Seitenfläche der Batterie in einer Umfangsrichtung bewegt.

2. Die Batterie-Identifizierungsvorrichtung nach Anspruch 1, wobei die Drehachse durch die Mitte einer Endfläche der Batterie und die Mitte der anderen Endfläche der Batterie verläuft.

3. Die Batterie-Identifizierungsvorrichtung nach Anspruch 1, wobei der Sensor das Magnetfeld misst, während er sich parallel zur Drehachse bewegt.

4. Die Batterie-Identifizierungsvorrichtung nach Anspruch 1, ferner aufweisend:
einen Fixiermechanismus, der so ausgebildet ist, dass er eine Lage der röhrenförmigen Batterie fixiert, wobei
der Sensor so ausgebildet ist, dass er ein Magnetfeld entlang eines Außenumfangs der Batterie misst, während er sich in einer Mittelachsenrichtung der Batterie bewegt, wenn die Lage der Batterie durch den Fixiermechanismus fixiert ist.

5. Die Batterie-Identifizierungsvorrichtung nach Anspruch 1, wobei das gewickelte Produkt Elektrodenableiter aufweist, die mit den Elektroden elektrisch verbunden sind, und
wobei der Hardwareprozessor, aufgrund einer Verteilung in einer Umfangsrichtung der Batterie einer Magnetfeldkomponente in Umfangsrichtung oder einer Verteilung in Längsrichtung der Magnetfeldkomponente in der Umfangsrichtung, Positionen der Elektrodenableiter erkennt.

6. Die Batterie-Identifizierungsvorrichtung nach Anspruch 1, wobei das gewickelte Produkt Elektrodenableiter aufweist, die mit den Elektroden elektrisch verbunden sind, und
wobei der Hardwareprozessor, aufgrund einer Intensität einer Magnetfeldkomponente in Längsrichtung der Batterie oder einer Intensität der Magnetfeldkomponente in einer Richtung senkrecht zur Längsrichtung, die Anzahl der Elektrodenableiter erkennt.

7. Die Batterie-Identifizierungsvorrichtung nach Anspruch 1, wobei das gewickelte Produkt Elektrodenableiter aufweist, die mit den Elektroden elektrisch verbunden sind, und
wobei der Hardwareprozessor, aufgrund einer Position, an der sich eine Verteilung von Messwerten zum Zeitpunkt des Ladens und eine Verteilung von Messwerten zum Zeitpunkt des Entladens einer Magnetfeldkomponente in einer Richtung senkrecht zur Längsrichtung der Batterie kreuzen, eine Länge oder eine Breite der Elektrodenableiter erkennt.

8. Ein Verfahren zur Identifizierung einer Batterie, bei dem eine röhrenförmige Batterie identifiziert wird, die ein gewickeltes Produkt enthält, in dem Elektroden gewickelt sind, wobei das Verfahren zur Identifizierung der Batterie von einer Batterie-Identifizierungsvorrichtung durchgeführt wird, die einen Sensor und einen Drehmechanismus aufweist, wobei das Verfahren zur Identifizierung der Batterie umfasst:
Messen eines Magnetfelds in der Nähe einer Oberfläche der Batterie durch den Sensor, während sich dieser relativ zu einer Seitenfläche der Batterie bewegt;
Drehen der Batterie durch den Drehmechanismus um eine durch beide Endflächen der röhrenförmigen Batterie als Drehachse verlaufenden Achse;
Anlegen eines Stroms an die Batterie;
Messen eines durch das Anlegen des Stroms erzeugten Magnetfelds; und
Erfassen eines Batterie-Typs, der durch Vergleichen des Ergebnisses der Magnetfeldmessung mit Magnetfeldinformationen, welche mit einem Batterie-Typ korrelieren, bestimmt wird,
wobei der Sensor das Magnetfeld misst, während er sich unter Verwendung des Drehmechanismus in einer Umfangsrichtung relativ zur Seitenfläche der Batterie bewegt.

9. Ein nichtflüchtiges Speichermedium, das ein Programm speichert, wobei das Programm eine Batterie-Identifizierungsvorrichtung mit einem Sensor und einem Drehmechanismus zum Identifizieren einer röhrenförmigen Batterie, welche ein gewickeltes Produkt enthält, in dem Elektroden gewickelt sind, dazu veranlasst, Folgendes durchzuführen:
Messen eines Magnetfelds in der Nähe einer Oberfläche der Batterie durch den Sensor, während sich dieser relativ zu einer Seitenfläche der Batterie bewegt;
Drehen der Batterie durch den Drehmechanismus um eine durch beide Endflächen der zylindrischen Batterie als Drehachse verlaufenden Achse;
Anlegen eines Stroms an die Batterie;
Messen eines durch das Anlegen des Stroms erzeugten Magnetfelds; und
Erfassen eines Batterie-Typs, der durch Vergleichen des Ergebnisses der Magnetfeldmessung mit Magnetfeldinformationen, welche mit einem Batterie-Typ korrelieren, bestimmt wird,
wobei der Sensor das Magnetfeld misst, während er sich unter Verwendung des Drehmechanismus in einer Umfangsrichtung relativ zur Seitenfläche der Batterie bewegt.

## Revendications

1. Dispositif d'identification de batterie pour identifier une batterie tubulaire incluant un produit enroulé dans lequel des électrodes sont enroulées, le dispositif d'identification de batterie comprenant :
un capteur configuré pour mesurer un champ magnétique à proximité d'une surface de la batterie tout en se déplaçant par rapport à une surface latérale de la batterie ;
un mécanisme rotatif configuré pour faire tourner la batterie avec un axe traversant les deux surfaces d'extrémité de la batterie tubulaire en tant qu'axe de rotation ;
un dispositif de stockage stockant un programme ; et
un processeur matériel,
dans lequel le processeur matériel exécute le programme stocké dans le dispositif de stockage pour effectuer :
l'application d'un courant à la batterie ;
la mesure d'un champ magnétique généré avec l'application du courant ; et
l'acquisition d'un type de la batterie qui est déterminé par comparaison du résultat de mesure du champ magnétique avec des informations de champ magnétique corrélées à un type de batterie,
dans lequel le capteur mesure le champ magnétique tout en se déplaçant dans une direction circonférentielle par rapport à la surface latérale de la batterie à l'aide du mécanisme rotatif.

2. Dispositif d'identification de batterie selon la revendication 1, dans lequel l'axe de rotation traverse le centre d'une surface d'extrémité de la batterie et le centre de l'autre surface d'extrémité de la batterie.

3. Dispositif d'identification de batterie selon la revendication 1, dans lequel le capteur mesure le champ magnétique tout en se déplaçant parallèlement à l'axe de rotation.

4. Dispositif d'identification de batterie selon la revendication 1, comprenant en outre :
un mécanisme de fixation configuré pour fixer une orientation de la batterie tubulaire, dans lequel
le capteur est configuré pour mesurer un champ magnétique le long d'une circonférence externe de la batterie tout en se déplaçant dans une direction d'axe central de la batterie lorsque l'orientation de la batterie est fixée par le mécanisme de fixation.

5. Dispositif d'identification de batterie selon la revendication 1, dans lequel le produit enroulé inclut des languettes d'électrode connectées électriquement aux électrodes, et
dans lequel le processeur matériel reconnaît des positions des languettes d'électrode sur la base d'une distribution, dans une direction circonférentielle de la batterie, d'une composante de champ magnétique dans la direction circonférentielle ou d'une distribution, dans une direction longitudinale, de la composante de champ magnétique dans la direction circonférentielle.

6. Dispositif d'identification de batterie selon la revendication 1, dans lequel le produit enroulé inclut des languettes d'électrode connectées électriquement aux électrodes, et
dans lequel le processeur matériel reconnaît le nombre de languettes d'électrode sur la base d'une intensité d'une composante de champ magnétique dans une direction longitudinale de la batterie ou d'une intensité de la composante de champ magnétique dans une direction perpendiculaire à la direction longitudinale.

7. Dispositif d'identification de batterie selon la revendication 1, dans lequel le produit enroulé inclut des languettes d'électrode connectées électriquement aux électrodes, et
dans lequel le processeur matériel reconnaît une longueur ou une largeur des languettes d'électrode sur la base d'une position à laquelle se croisent une distribution de valeurs mesurées au moment de la charge et une distribution de valeurs mesurées au moment de la décharge d'une composante de champ magnétique dans une direction perpendiculaire à une direction longitudinale de la batterie.

8. Procédé d'identification de batterie permettant d'identifier une batterie tubulaire incluant un produit enroulé dans lequel des électrodes sont enroulées, le procédé d'identification de batterie étant réalisé par un dispositif d'identification de batterie ayant un capteur et un mécanisme rotatif, le procédé d'identification de batterie comprenant :
la mesure, par le capteur, d'un champ magnétique à proximité d'une surface de la batterie tout en se déplaçant par rapport à une surface latérale de la batterie ;
la rotation, par le mécanisme de rotation, de la batterie avec un axe traversant les deux surfaces d'extrémité de la batterie tubulaire en tant qu'axe de rotation ;
l'application d'un courant à la batterie ;
la mesure d'un champ magnétique généré avec l'application du courant ; et
l'acquisition d'un type de la batterie qui est déterminé par comparaison du résultat de mesure du champ magnétique avec des informations de champ magnétique corrélées à un type de batterie,
dans lequel le capteur mesure le champ magnétique tout en se déplaçant dans une direction circonférentielle par rapport à la surface latérale de la batterie à l'aide du mécanisme rotatif.

9. Support de stockage non transitoire stockant un programme, le programme amenant un dispositif d'identification de batterie ayant un capteur et un mécanisme rotatif destiné à identifier une batterie tubulaire incluant un produit enroulé dans lequel des électrodes sont enroulées pour réaliser :
la mesure, par le capteur, d'un champ magnétique à proximité d'une surface de la batterie tout en se déplaçant par rapport à une surface latérale de la batterie ;
la rotation, par le mécanisme de rotation, de la batterie avec un axe traversant les deux surfaces d'extrémité de la batterie tubulaire en tant qu'axe de rotation ;
l'application d'un courant à la batterie ;
la mesure d'un champ magnétique généré avec l'application du courant ; et
l'acquisition d'un type de la batterie qui est déterminé par comparaison du résultat de mesure du champ magnétique avec des informations de champ magnétique corrélées à un type de batterie,
dans lequel le capteur mesure le champ magnétique tout en se déplaçant dans une direction circonférentielle par rapport à la surface latérale de la batterie à l'aide du mécanisme rotatif.
